# EUROPEAN PATENT APPLICATION

(11) **EP 1 369 931 A1**
(43) Date of publication of application: **10.12.2003**
(21) Application number: 02021221.3
(22) Date of filing: 18.09.2002
(51) Int. Cl.: H01L 31/0236, H01L 31/052, H01L 31/20, H01L 31/0224

(54) **Solar cell and its manufacturing method, metal plate for the same**

(30) Priority: 03.06.2002 JP 2002161326
(71) Applicant: Hitachi, Ltd., Chiyoda-ku, Tokyo 101-8010 (JP)
(72) Inventor: Kubo, Masaharu, Hitachi, Ltd., Int. Prop. Gp., Chiyoda-ku, Tokyo 100-8220 (JP); Naitou, Takashi, Hitachi, Ltd., Int. Prop. Gp., Chiyoda-ku, Tokyo 100-8220 (JP); Mori, Mutsuhiro, Hitachi, Ltd., Int. Prop. Gp., Chiyoda-ku, Tokyo 100-8220 (JP); Hatano, Mutsuko, Hitachi, Ltd., Int. Prop. Gp., Chiyoda-ku, Tokyo 100-8220 (JP); Sawai, Yuichi, Hitachi, Ltd., Int. Prop. Gp., Chiyoda-ku, Tokyo 100-8220 (JP)
(74) Representative: Beetz & Partner Patentanwälte

(57) **Abstract**

The invention relates to a solar cell apparatus which can prevent occurrences of peeling, warping and cracking of a film due to a temperature change in heating and cooling, etc. in a production process of a large-area solar cell panel and can cause an absence of a development of defects in the production process, a production method of the solar cell apparatus, a metal plate for the solar cell apparatus, and a power generating plant. According to this invention, there is provided a solar cell apparatus containing a metal substrate (1), two silicon layers, one of the two silicon layers being formed in contact with a part of one surface of the metal substrate (1), a plurality of electrodes (2, 5) formed in contact with the other of the silicon layers, an external terminal (6, 7) formed on the other surface of the metal substrate (1), and an external terminal (6, 7) formed in contact with the electrode (2,5 ).

## Description

### FIELD OF THE INVENTION

This invention relates to a novel solar cell apparatus comprising silicon as a main constituent, a production method of the same, a metal plate for the same, and a power generating plant.

### BACKGROUND OF THE INVENTION

JP-A-2000-223421 and JP-A-2000-243712 disclose a formation of a polycrystalline Si film of a solar panel by means of Cat CVD, JP-A-8-88172 discloses a formation of a polycrystalline Si film of a solar panel by means of CVD, JP-A-2001-168055 and JP-A-2001-168029 disclose a formation of a poly Si film of a solar panel by means of Cat CVD, JP-A-63-40314 discloses a formation of Si film of a solar panel by means of Cat CVD, JP-A-4-349616 and JP-A-4-349618 disclose a formation of a polycrystalline Si film for TFT by means of thermal CVD and plasma CVD, and JP-A-2000-223730, JP-A-2000-196126 and JP-A-10-507312 disclose providing a means for tracking a solar light direction for a solar light panel.

### SUMMARY OF THE INVENTION

A solar cell is a cell which converts solar light into electricity through a p-n junction of a semiconductor, and has been known for long to have characteristic features of requiring no fuel replenishment and emitting no unnecessary combustion residue at the time of energy generation.

As to a method for constructing a solar cell by using a semiconductor, particularly a silicon material, there have been known (1) a method which uses monocrystalline silicon and (2) a method which uses polycrystalline (or poly) silicon or amorphous silicon (a-Si).

Though the structure which uses monocrystalline silicon gives a high photoelectric conversion efficiency of about 20%, it has a great disadvantage in that monocrystalline silicon itself is expensive.

On the other hand, in the structure which uses polycrystalline or amorphous silicon (a-Si) as a photoelectric conversion element, its low photoelectric conversion efficiency of 8-12% is a serious problem. Main cause of the low photoelectric conversion efficiency is that, (1) though the short lifetime of electrons or holes formed as the result of photoelectric conversion is also a factor, (2) an electric resistance of semiconductors of bulk from a junction part till to an external electrode part is too high, which leads to a power loss.

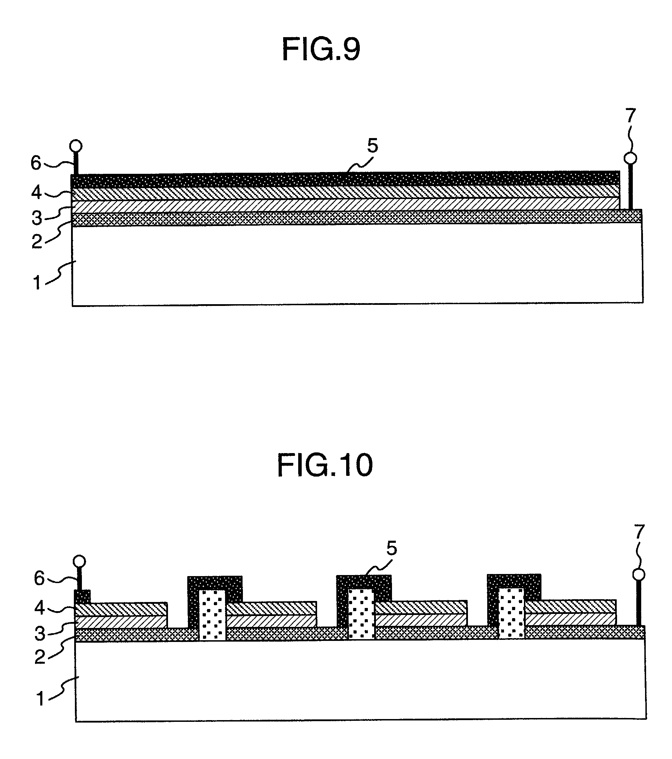

Figs. 9 and 10 respectively show a sectional view of a solar cell of the prior art using a-Si. In Fig. 9, the substrate 1 used is an insulating substrate transparent to solar light, such as a glass substrate, on a principal plane of which a transparent electrode 2 is formed for example by sputtering. The transparent electrode 2 used has been ITO film (popular name; Nesa film). On an upper plane thereof, a film of a-Si or polycrystalline Si has been formed for example by plasma CVD. At the initial period of a film formation, monosilane gas is decomposed with diborane used as a doping gas to form about 3 µm thick film of P-type a-Si 3, then the doping material was changed to phosphorus and about 1 µm thick film of N-type a-Si 4 is formed. Thereafter, aluminum film is formed for example by sputtering to serve as an upper electrode 5. Then, a part of the upper electrode 5 and a part of the a-Si layer are removed by photoetching, and external terminals 6 and 7 are connected thus to construct a solar cell. In the above-mentioned solar cell of a prior technology, solar light enters from a lower plane, that is, through a glass substrate.

Fig. 10 shows a sectional view of a solar cell constructed according to another prior technology. In Fig. 10, solar light enters from an upper surface. In Fig. 10, the substrate 1 uses, for example, glass. A lower electrode 2 is then formed thereon. The lower electrode 2 can be formed, besides with ITO film, by using a metal, for example aluminum. The lower electrode 2 is patterned for example by photoetching. On the upper surface of the lower electrode 2 are formed, according to the same procedure as described above, layers of p-n junctions 3, 4 comprising a-Si and a layer of the upper electrode 5. Thereafter, a part of the upper electrode 5 and parts of the α-Si layers 3 and 4 are removed by photoetching, and an upper terminal 6 and a lower terminal 7 are connected, thus to construct a solar cell. According to this structure, a solar cell of predetermined voltage can be provided by constructing a solar cell in the form of slit and connecting them in cascade.

The amorphous silicon (a-Si) solar cells of prior art described above have following problems to be solved. In Fig. 9, the ITO film has relatively high resistance and moreover needs to have good heat resistance, which necessitates an addition of an expensive material such as indium to tin. That is, a power loss due to resistance of the lower electrode is large, and the cell is disadvantageous also from an economical view point. In Fig. 10, since the lower electrode is of a slit structure, the power loss of the solar panel in bulk, particularly the power loss due to resistance at the P-type layer, can be reduced; on the other hand, since the structure is complicated, the cell has an economical disadvantage and moreover, since the solar light entering from the upper surface is not utilized for the solar cell at the cascade connection part, an effective area for receiving light is restricted.

Another serious problem of the prior art is that, owing to a difference in a thermal expansion coefficient of materials between the substrate (e.g. glass) 1 and α-Si 3 or 4, due to a temperature change in heating and cooling, etc. in a production process, a peeling, warping or cracking of a film tend to occur to cause a development of defects in the production process.

In any of the patent disclosures as described above, no description is given of a solar cell in which a silicon layer is formed onto a metal substrate.

The object of this invention is to provide a solar cell apparatus which can prevent occurrences of peeling, warping and cracking of a film due to a temperature change in heating and cooling, etc. in a production process of a large-area solar cell panel and can cause an absence of a development of defects in the production process, a production method of the solar cell apparatus, a metal plate for the solar all apparatus, and a power generation plant.

According to this invention, there is provided a solar cell apparatus comprising a metal substrate, two silicon layers, one of the two silicon layers being formed in contact with a part of one surface of the metal substrate, a plurality of electrodes formed in contact with the other of the silicon layers, an external terminal formed on the other surface of the metal substrate, and an external terminal formed in contact with the electrode.

According to this invention, there is further provided a solar cell apparatus comprising a metal substrate which has a plurality of projections formed on one surface thereof, two silicon layers, one of the two silicon layers being formed in contact with the projections; and a solar cell apparatus comprising a metal substrate in which a part of one surface thereof has been insulated, two silicon layers, one of the two silicon layers being formed in contact with a non-insulated part of the substrate. It is preferable that a planar form of the electrode is of a lattice structure or a honey-comb structure and that the metal substrate is aluminum. Thus, the characteristic feature of this invention lies in that the substrate of the solar cell is a metal plate and that the metal plate has a grooved structure for avoiding its warpage. The aluminum substrate has also an effect to enhance a power generation efficiency by reflecting a transmitted light.

Other objects, features and advantages of the invention will become apparent from the following description of the embodiments of the invention taken in conjunction with the accompanying drawings.

### BRIEF DESCRIPTION OF THE DRAWINGS

Figs. 1A and 1B show a plan view and a sectional view, respectively, of a solar cell apparatus using a metal plate having projections of this invention.
Figs. 2A, 2B and 2C show sectional views showing the production steps of a solar cell apparatus using a metal plate having projections of this invention.
Fig. 3 is a plan view of amorphous silicon cut grooves in a solar cell apparatus using a metal plate having projections of this invention.
Figs. 4A to 4K show sectional views showing the production steps of a solar cell apparatus using a metal plate having projections of this invention.
Figs. 5A, 5B and 5C show a plan view, an enlarged view thereof, and a sectional view of a metal substrate having a projection structure of this invention, respectively.
Figs. 6A and 6B show a plan view and a sectional view, respectively, of a solar cell apparatus using a metal substrate having no projection of this invention.
Fig. 7 shows a plan view of a solar cell apparatus using a metal plate having projections of this invention.
Figs. 8A to 8H show sectional views showing the production steps of a solar cell apparatus using a metal plate having projections of this invention.
Fig. 9 shows a sectional view of a solar cell apparatus of the prior art.
Fig. 10 shows a sectional view of a solar cell apparatus of the prior art.

### (Description of Reference Numerals)

1 --- substrate, 2 --- lower electrode, 3 --- p-type a-Si layer, 4 --- n-type a-Si layer, 5 --- upper electrode, 6,7 --- external terminal, 8 --- aluminum metal plate, 9 --- aluminum projection, 10 --- ceramics flame-coating film, 11 --- glass layer, 12 --- CVD oxidation layer, 13 --- heater provided with vacuum chuck, 14 --- amorphous silicon cut groove, 15 --- interlayer hole, 16 --- antireflection film, 17 --- almite layer, 18 --- glass or resin, 19 --- photosensitive polymer, 20 --- cured part of photosensitive polymer, 21 --- glass or resin, 22 --- gap due to patterning.

### DETAILED DESCRIPTION OF THE INVENTION

According to this invention, there is provided a process for producing a solar cell apparatus which can comprise one or more of the steps of: forming projections on one surface of a metal substrate; forming a ceramics layer and a glass layer successively on said one surface; forming two silicon layers on a surface of the glass layer; forming a glass layer on the surface of the silicon layers; forming a predetermined cut into the silicon layers through the glass layer; forming a plurality of through-holes in the glass layer on the silicon layers so that the through-holes come in contact with an upper silicon layer of the silicon layers; forming an electrode in the through-hole; forming an antireflection film on the glass layer on the silicon layers; and/or forming external terminals on the electrode and on the other surface of the metal substrate. It is preferable that the antireflection film comprises a glass layer and is formed by a sol-gel method.

According to this invention, there is further provided a process for producing a solar cell apparatus which can comprise at least one of the steps of: forming two silicon layers on one surface of a metal substrate; forming a photosensitive polymer layer on the silicon layers and partially curing the polymer in a predetermined planar form; removing the partially cured part of the photosensitive polymer; removing, by etching, a part of the two silicon layers below the removed part of the photosensitive polymer, to form a through-hole which reaches a surface of the metal plate; filling an insulating material in the removed part of the silicon layers so that the insulating material reach a part of an upper silicon layer of the silicon layers removed by etching; forming an electrode on the insulating material; and/or forming external terminals on the electrode and on the other surface of the metal plate.

It is preferable that amorphous silicon layers are used as the two silicon layers and the two layers are successively formed by means of a catalyst CVD by first forming a p-type amorphous silicon layer (p-type a-Si layer) to which boron is doped and then forming an n-type silicon layer (n-type a-Si layer) to which phosphorus is doped. Then the catalyst CVD can be conducted by heating a tungsten wire to a high temperature to serve as a catalyst, forming the p-type silicon layer by the use of monosilane and diborane gas; then forming the n-type silicon layer by the use of monosilane and phosphine gas. In an actual production process, it is important to control an incorporation of H (hydrogen) simultaneously with Si which are generated by a decomposition of SiH₄ (monosilane) in the a-Si layer part. H can be incorporated as a terminator into a portion, to which Si atom is not bonded, to provide an effect to prevent a recombination of a pair of a positive hole and an electron generated. At that time, it comes to be possible to convert a form of a-Si to a polycrystalline layer in the form of frost column by suitably setting up conditions. The above-mentioned are on a basic p-n junction structure. As regards the junction of a-Si, it can be either of a structure in which a lower part fs a p-layer and an upper part is an n-layer or of a reverse structure.

In an attempt to further enhance an efficiency by the use of the above-mentioned silicon layer, p-n junction portion of a-Si is made into a pin structure and most of a light-electricity conversion is carried out in an i layer. At that time, as regards a thickness of a whole a-Si and p-i layer, for example a thickness of a pin layer of about tens nm, 200-300 nm, or up to tens µm is permissible. In the basic structure figure of the solar cell of the present invention, a portion, which is described as p layer, represents p-i layer.

According to this invention, there are provided a metal plate for a solar cell. The metal plate can comprise a metal substrate having a plurality of projections regularly arranged on one surface of the metal substrate. Further a metal plate for a solar cell which metal plate can comprise a metal substrate having a plurality of projections regularly arranged on one surface of the metal substrate and having a thick part along a whole peripheral part of the substrate is provided.

It is preferable that the metal substrate comprises a component selected from the group consisting of aluminum, aluminum alloy, and/or nickel-iron based alloy containing 35-45% by weight of nickel. It is further preferable that each of the projections has a diameter of 0.2-0.8 mm and a height of 0.1-0.5 mm. It ist further preferable that an insulating layer is formed on the projections-formed surface, and/or that the insulating layer is formed on the peripheral part and a whole surface excluding edges of the projections.

For example, when Al plate thickness is 0.5 mm and a pitch of a battery cell is 10 mm x 10 mm, an irregularity (concavity and convexity) of a pitch of from 0.5 to 1.0 mm in both longitudinal direction and transverse direction can be utilized. A height of the irregularity can be in a degree so that a light can be sufficiently absorbed in a concavity portion.

According to this invention, there is provided a power generating plant provided with any of the above-mentioned solar cell apparatus, a solar cell apparatus produced by the above-mentioned production process of a solar cell apparatus, and/or a solar cell apparatus constructed by using the above-mentioned metal plate for a solar cell apparatus.

Thus, in this invention, a part or a whole of a principal plane of a metal substrate is in contact with one of two silicon layers. Further a plurality of electrodes of a solar cell are in contact with the other of the two silicon layers, and/or the substrate is constructed so that the silicon layer be not necessarily in contact with its whole surface.

By virtue of the structure of this invention wherein a metal (aluminum, etc.) is directly connected to one principal surface (lower side: a side which solar light does not enter directly) of a semiconductor a-Si constituting a solar cell, a resistance of a bulk a-Si semiconductor can be greatly reduced. In addition, a restriction in manufacturing due to a difference of thermal expansion caused by a difference on material between metal plate 1 and a-Si can be released. Furthermore, by forming projections on the metal substrate, the performance characteristics of the completed solar cell can be improved.

As to a means for producing the solar cell of this invention, there can be mentioned, for example, a method of forming a silicon layer by vapor phase deposition on at least one surface of a metal plate. Plasma or catalyst can be used for the vapor phase deposition (CVD). By providing projections in the metal plate onto which silicon film is to be formed, a warping and cracking of a solar cell panel caused by a stress due to a difference of thermal expansion coefficient between the semiconductor and the metal plate can be greatly reduced as compared with the previous structure in which a whole lower side of a semiconductor (i.e. a side which solar light does not enter directly) is contacted with a metal plate.

The projections can be either macroscopic ones formed by mechanical working or microscopic ones prepared by a means such as surface oxidation treatment. When a metal plate having no projection is used, an effect equivalent to that by the projections can be obtained by partially applying, at a step after the silicon layer has been formed, an etching treatment to form grooves or holes, and filling gaps with glass or resin. When two solar cell panels prepared by the same method are laminated by using soldar, etc., the warpages of respective panels can be canceled by each other and, since the product constitutes a double-sided solar cell, a power generation efficiency can be enhanced. When it is intended to prepare a double-sided solar cell while omitting the lamination step, it can be achieved by using an apparatus capable of CVD film-forming on both surfaces of a metal plate.

Projections which can play a similar role can also be easily obtained in the following way. That is, immediately after the step of forming an a-Si layer on an Al substrate, or immediately after forming a transparent electrode (ITO film) while successively heating the substrate, grooves are cut with a thread thaw (saw) to obtain grooves with an appropriate pitch. When it is intended, for example, to cut grooves in the form of grating onto an Al substrate 1000 mm in length and 1000 mm in width, a thread thaw assembly comprising about 50 thread thaws each about 10-100 µm in diameter and 1500 mm in length arranged with a distance of about 0.5-10 mm can be used, whereby the groove cutting can be completed with a small number of process steps. For cutting grooves in the form of grating, the stage is rotated 90 degrees, and the substrate (Al substrate having a-Si film formed thereon) on the stage is also rotated together, and then thread thaw work (in the piano wires form) is applied again. Since the cut-in depth is about 3-50 µm, the work can be achieved by pressing the thread thaw against the Al substrate and making it go and return once or so. The thread thaw used herein is, in a sense, analogous to piano wires used for slicing Si ingot in preparing a Si substrate (wafer). By introducing the step of groove-cutting with a thread thaw just after the step of forming a-Si film or the step of forming a transparent electrode (ITO film) succeeding to the a-Si film formation, grooves are cut in a state that the Al substrate is heat-expanded such that a stress which develops between a-Si and Al on cooling can be relaxed. The pitch of cut-in is determined based on calculation with priority given to the power generation efficiency of the solar cell and, though it may vary depending on the materials, a pitch of about 0.5-10 mm is generally considered to be appropriate. A cut-in depth of about 3-50 µn signifies that grooves can be cut-in through the surface ITO layer, n-Si layer, lower p-Si layer and lower Al substrate, and consequently, when an upper electrode is formed thereon, a problem of the p-Si layer and the n-Si layer becoming electrically communicated with each other can occur. In such a case, a resin is cast into the cut-in part thereby to insulate the p-Si layer, n-Si layer and lower Al substrate from one another. The insulating layer can comprise an inorganic material prepared by a sol-gel method etc. By controlling the thickness of the cast resin to about 3 to 47 µm, then forming the upper electrode, and filling the remaining part of the groove, it becomes possible to electrically communicate an upper Al bus bar electrode, formed for example by flame coating, from a side face of the n-Si layer, and thus a desirable structure can be obtained. Furthermore, since the thermal expansion coefficient of the cast-in resin is larger than that of a-Si, the above-mentioned procedure contributes also to a stress relaxation at the time of a substrate cooling.

The upper transparent electrode (ITO) film is formed by coating a raw material, followed by high temperature treatment. Also for suppressing a warpage which may occur before groove cutting, it is desirable that the above-mentioned groove cutting is done including the ITO layer. Thereafter, the system thus obtained is tightly closed with a cover of transparent resin, etc. to obtain the solar cell apparatus of this invention. However, the closed structure with a transparent cover is merely one example of preferred embodiments of the solar cell apparatus, and in no way limits this invention.

To enhance the power generation efficiency further, it is advisable to provide, for example, an antireflection film for surpressing a reflection at the semiconductor surface. When it is intended to increase an area of the above-mentioned solar cell panel, it is concerned that a cracking may develop at the semiconductor part due to a stress caused by a difference on thermal expansion coefficient between the semiconductor and the metal plate. However, in such a case, by adopting a structure in which a large number of semiconductors each having a small area are brought in contact with the metal plate, a thermal stress developed inside the semiconductor can be relaxed and crackings in the semiconductor surface can be decreased. The above-mentioned structure resembles, in its overall image, for example, one in which the semiconductors are arranged in the form of a honey-comb structure or one in which the semiconductors are arranged like tiles spread all over a floor. Alternatively, the above-mentioned problem can also be obviated by previously providing cuts (gaps for stress relaxation) in the semiconductor part to relax the thermal stress which develops inside the semiconductor.

### EXAMPLES

### Example 1

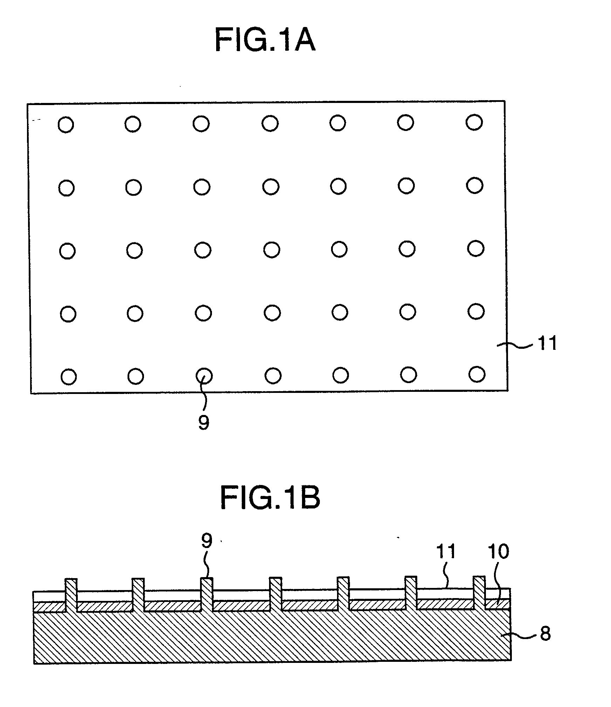

The production method of a solar cell of this invention is described below with reference to Figs. 1-6. Figs. 1A and 1B show a plan view of the projection side of a metal substrate of this invention and its sectional view, respectively. The metal substrate 8 of this Example is a quadrangle of 1 m square, on the whole peripheral part of which is formed a thick part having a square shape and a predetermined width (30 mm) and having the same height as that of the projection 9. First, as shown in Figs. 1A and 1B, a metal substrate 8 having rod-form projections 9 is prepared. Though the material of the metal plate 8 is preferably aluminum, iron or copper or their alloy (e.g., alloy or iron with 35-45% by weight of nickel (42 alloy)) may also be used. In this Example, the thickness of the metal plate 8 is about 1 mm, the diameter of the projection 9 is 1-3 mm and the projection length is 1 mm. The projections 9 may be in the form of rod, wedge, and the like and are arranged regularly and squarely as shown in the Figure.

The projections 9 are formed, in this Example, by casting aluminum melting at high temperature (e.g., 1000°C) into a mold which is made of a heat-resistant metal and has concave parts corresponding to rod-form projections 9, and by rolling, along therewith, one principal plane of the metal plate. For the mold, besides metals, other heat resistant materials, e.g., graphite or SiC (silicon carbide) may also be used. According to circumstances, it may be as well to form an a-Si film on the front side of a plane aluminum plate having no projection. The rod-form projection 9 may also be formed by rolling. In order that the product be easily pulled out from the mold or roll in casting or rolling, a slight inclination is provided.

Then, as shown in Fig. 1B, ceramics (e.g., alumina) 10 is attached by flame coating in a thickness of about 50-100 µm onto the surface of the metal substrate 8 of the projection 9 side. Such flame coating film can be obtained by using a plurality of flame coating nozzles arranged with the same distances as those of the projections formed on the metal substrate. Alternatively, it may be obtained by arranging a flame coating nozzle between the projections and repeating a step of forming linear flame coating film.

On the surface of ceramics 10 is formed, for example by the sol-gel method, a glass layer 11 about 10 µm in thickness. This step may be omitted when the adhesion of the ceramics is good.

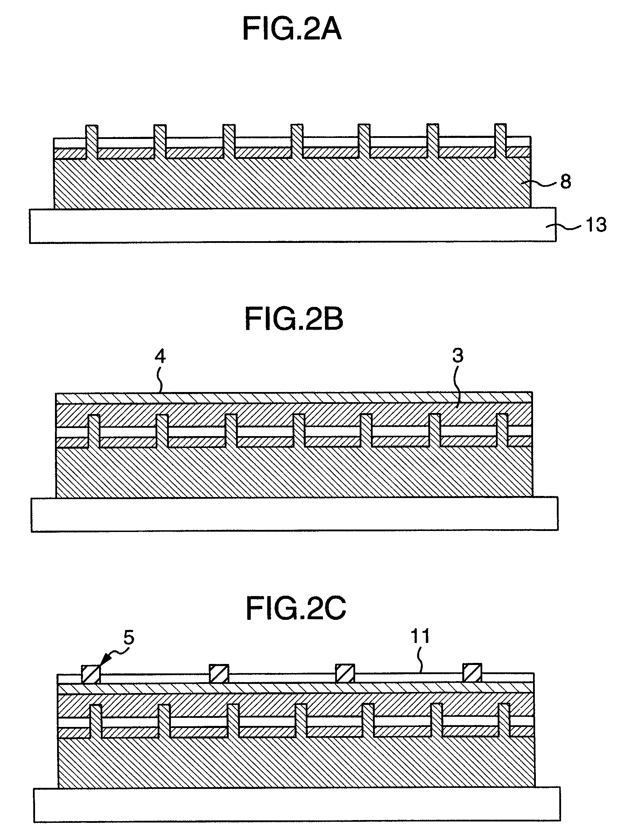

Then, as shown in Figs. 2A to 2C, a silicon layer is formed on the metal substrate 8 by vapor phase deposition. For the vapor phase deposition (CVD), plasma or catalyst can be used. In this Example, the silicon layer is formed by catalyst CVD (Cat CVD).

A metal substrate 8 shown in Fig. 1 is placed in a CVD chamber as shown in Fig. 2A. For fixing and heating the metal plate 8, the metal plate 8 is placed on a heater 13 provided with a vacuum chuck. The heating temperature of the metal plate 8 is set for example at 400°C. The atmosphere in the CVD chamber is pressurized to 3 atm with an inert gas, such as argon.

In the catalyst CVD (Cat CVD), for example a tungsten wire is heated to about 2000°C, and monosilane is decomposed with the heated tungsten wire as catalyst, to form a silicon layer on the metal plate 8. At the time of film-forming, simultaneously with monosilane, diborane gas, for example, is introduced to dope boron to the silicon layer. Thus, as shown in Fig. 2, a p-type a-Si layer 3 is formed in a thickness of, for example, 5 µm.

In the above-mentioned procedure, the diborane gas is changed in the midway to phosphine to form a phosphorus-doped, namely n-type, silicon layer in a thickness of about 1 µm. In the above-mentioned steps ranging from forming the glass layer to forming the n-type silicon layer 4, hydrogen gas can be added to improve the film quality of the silicon layer further.

After the silicon layer has been formed, a mask with a pattern is used to form an upper electrode 5, and then, as shown in Fig. 2C, a glass layer 11 is formed as an insulating film by means of CVD, etc. The metal substrate 8, while in the heated state, is taken out of the CVD chamber, and then photosensitive resist is coated thereon.

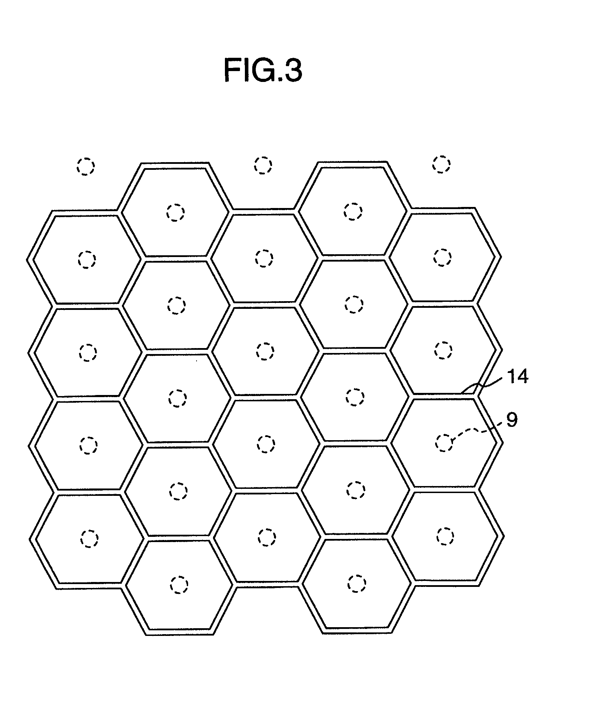

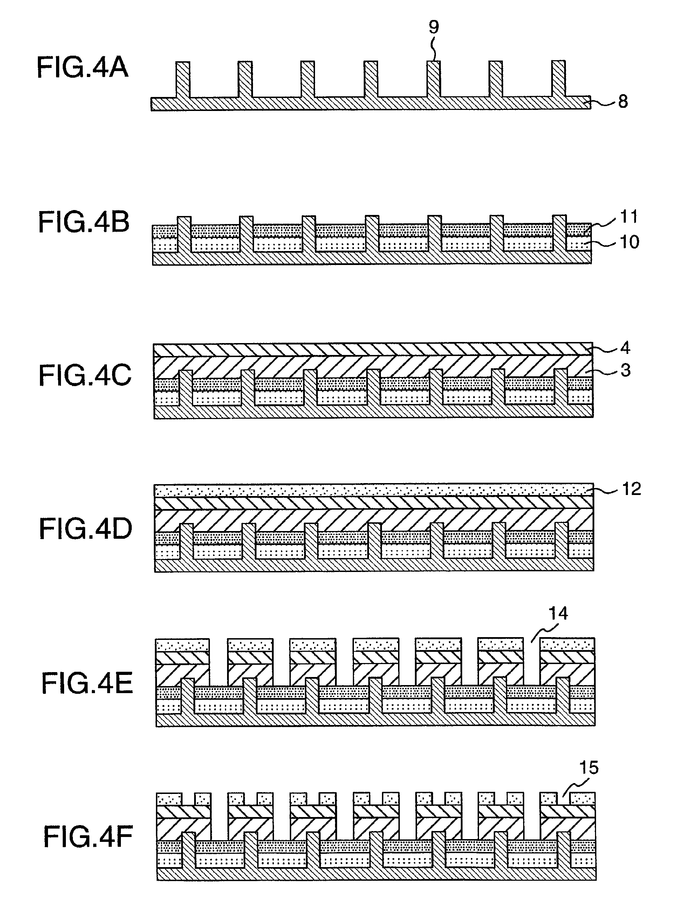

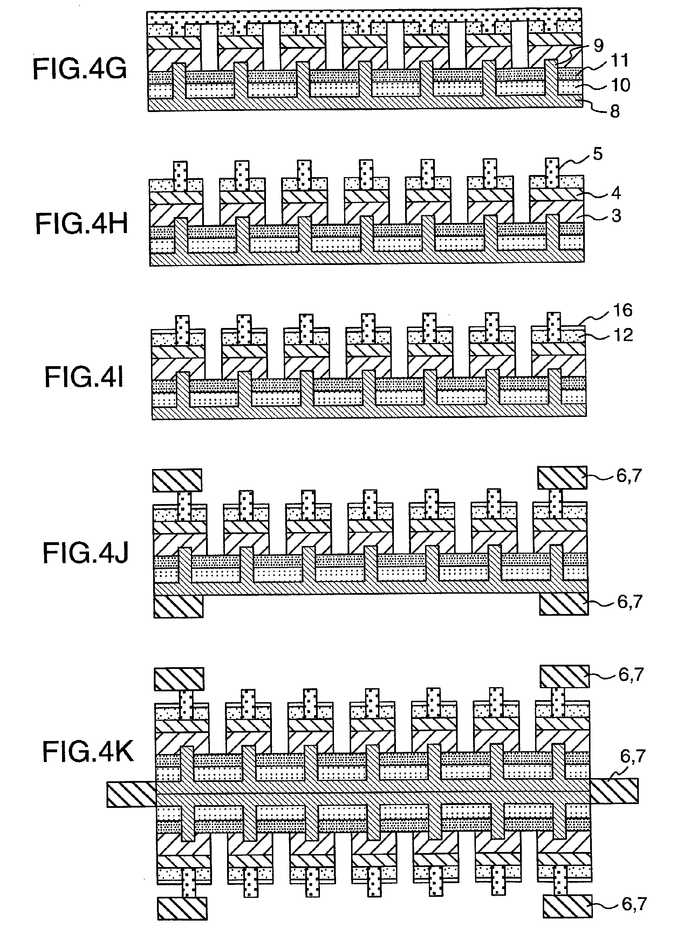

Fig. 3 shows a structure of the α-Si layer of this Example which has a honey-comb form groove 14 and wherein the upper end of at least one Al projection 9 is stuck to each of the honey combs. In the groove 14 is formed an upper electrode 5 in a later step. After the resist has been hardened, as shown in Fig. 3, a plan view of the principal part of the solar cell in this Example, the resist is exposed to light by irradiating ultraviolet light from the upper side of a mask which is a glass-material having thereon chromium thin film having a pattern carved in the form of honey-comb. Then the resist is removed along the part (contour of honey-comb) in which the resist has undergone change in material as the result of reaction with ultraviolet light, and then the glass layer 11 is removed, for example, by using a liquid mixture of HF and HN0₃. The upper electrode 5 shown in Fig. 2C is formed as shown in Figs. 4 described later. After the above-mentioned working has been finished, heating of the heater is stopped and the system is returned to ordinary temperature, whereby the deformation (warpage) of the metal plate can be suppressed to the minimum. The projection 9 is arranged at the center of the contour of the honey-comb. In Fig. 3, the a-Si layer for a solar cell is provided with a groove formed in the shape of honey-comb. This invention is featured in that the upper end of at least one Al projection 9 is stuck to a-Si in each of the honey-combs.

Figs. 4A to 4K show sectional views showing the entire steps including the production steps of a solar cell described above. Steps shown on Fig. 3 and after are shown in Fig. 4F and after. Thus, in Fig. 4F, an interlayer hole 15 is formed by photoetching on a CVD oxidation film 12 formed by CVD.
In 4D, a CVD oxidation film 12 is formed on the n-type a-Si layer 4.
In 4E, an amorphous silicon cut-in groove 14 is formed by using a mask.
In 4F, an interlayer hole 15 for forming an upper electrode 5 is formed on the CVD oxidation film 12.
In 4G, a metal layer 5 is formed on the upper surface by means of sputtering or vapor deposition. Alternatively, the metal layer 5 is formed by printing Ag paste, or by flame-coating Al metal.
4H Again by photoetching, the metal layer 5 is worked into the form of slit, grating or honey-comb to obtain an upper electrode 5 for wiring. The upper electrode 5 may also be formed by using Nesa (ITO) film as the material. For reducing the sheet resistance of p-type a-Si of the upper surface, a thin film of transparent electrode (In-Sn type, etc.) is formed by means of printing, and an upper electrode bus is formed thereon with Ag paste in the form of backbone.
4I After the step 4H, an antireflection film 16 is coated by a sol-gel method.
4J To the upper electrode 5 and the metal substrate 8 which serves as the lower electrode are attached, on the both sides of the panel, for example by means of solder plating, external terminals 6 and 7 of a metal plate which serve as external takeoff electrodes. Thereafter, the resulting system is tightly closed with a cover of transparent resin or the like, to complete a solar cell apparatus. When the upper electrode 5 is in the form of slit, the upper electrode 5 of the inside is electrically connected at least at one end part thereof by a metal plate like external terminals 6 and 7; on the other hand, when it is in the form of grating or honey-comb, the electrodes are in electrical connection with each other, and external terminals may be either provided on the both sides as described above or omitted. The external terminals 6 and 7 are provided in a predetermined width over the whole width of the panel, and preferably comprise a copper plate.
4K In the step 41, two solar cell panels are laminated by using solder before an external terminal is formed in the metal substrate 8 which serves as the lower electrode, and thereafter an external terminal is formed in the lower electrode, whereby a double-sided solar cell apparatus is completed.

In the double-sided solar cell apparatus of this Example, it has been confirmed that the occurrence of peeling, warping and cracking of films due to temperature change caused by heating, cooling, etc. in the production step of a large-area solar cell panel can be prevented and the development of defects in the production step can be avoided.

The solar cell apparatus obtained in this Example can be placed in a large number on a "Mega-Float", a huge floating structure, constructed on the sea, whereby a power plant can be built with economical advantage. By shifting a solar cell apparatus to follow the movement of solar light, a high photoelectric conversion efficiency can be obtained all the time. In a double-sided solar cell apparatus, further, by placing the panel upright, efficient power generation can be achieved without conducting the above-mentioned shift to follow the movement of solar light.

### Example 2

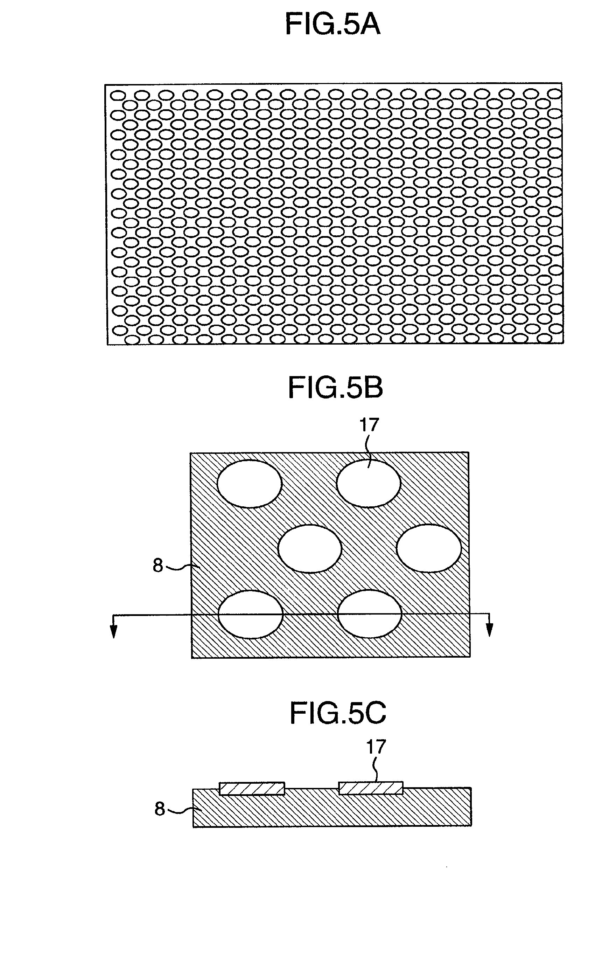

Figs. 5 show a plan view 5A, an enlarged view 5B thereof, and a sectional view 5C of 5B, of a metal plate illustrating another Example of this invention. They relate to a metal plate 8 and a projection 9. In Figs. 5, the projection 9 is formed with almite 17, a ceramics. By treating an aluminum metal plate 8, for example, by means of anode oxidation to form an almite portion, only that part of aluminum is corroded. At this time, the depth of corroded aluminum is about several µm, and a projection 9 of aluminum oxide of about 1.2 µm in height is obtained.

In this Example, it has been confirmed that by using almite, the occurrence of peeling, warping and cracking of film due to temperature change in heating, cooling, etc. in the production step of a large-area solar cell panel can be prevented and the development of defects in the production step can be avoided.

### Example 3

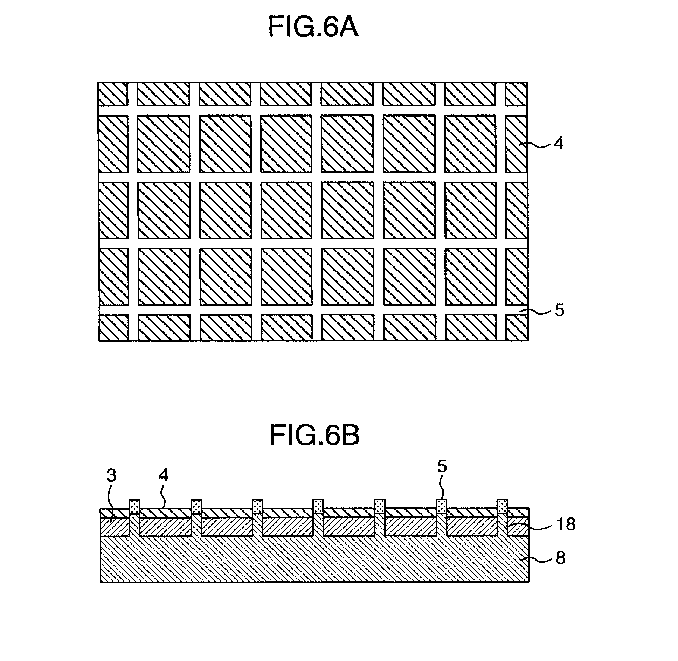

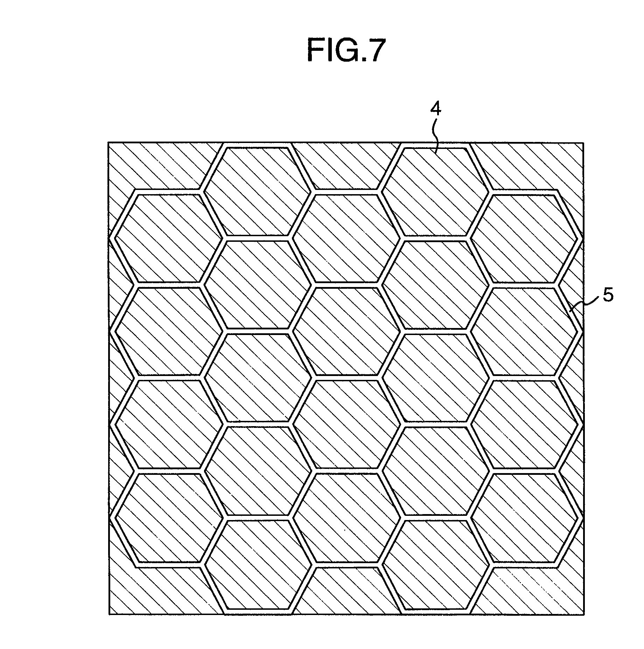

Figs. 6-8 show a plan view and a sectional view of a metal substrate of a solar cell apparatus illustrating another Example of this invention and sectional views illustrating the production step thereof. In this Example, as shown in Figs. 6 and 7, the metal substrate 8 itself has no projection structure and, instead, the a-Si layer formed on the metal substrate 8 of aluminum, etc. is separated in the form of square islands. Among the islands is filled glass or resin 18 to the midway of an n-type a-Si layer 4 of a groove separating the islands from each other. Thereafter, an upper electrode 5 is attached. The object of separating the a-Si layer in the form of square islands is, as described above, to prevent the warpage of the aluminum metal substrate 8 due to stress caused by thermal expansion difference between the metal substrate 8 and the a-Si layer. The island of a-Si may be partitioned in the form of honey-comb as shown in Fig. 7, and an upper electrode 5 may be attached in the same manner as above. The external electrodes are provided on the both sides of the panel as in Example 1.

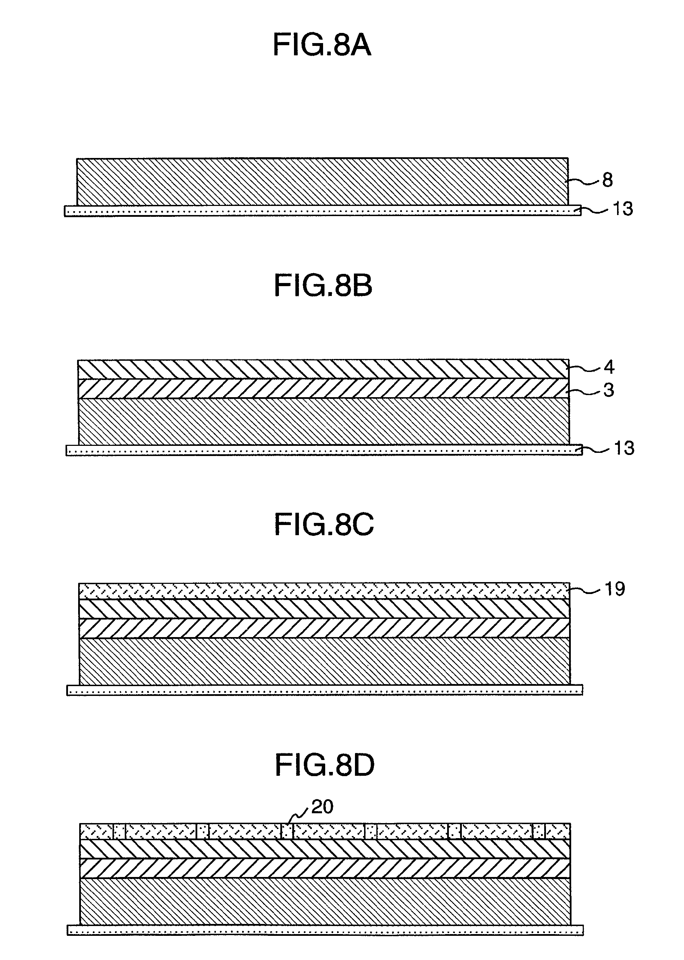

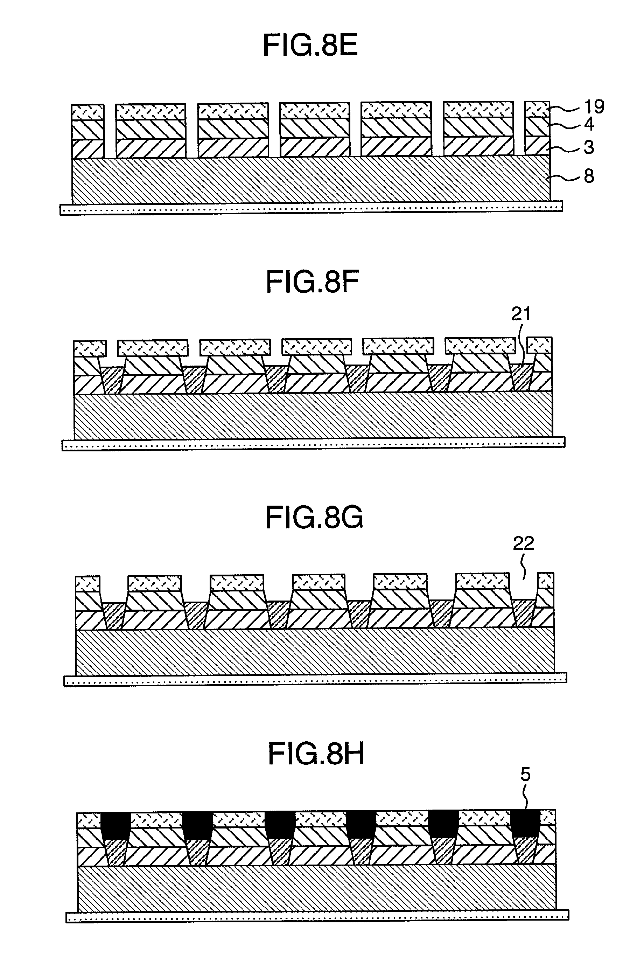

Figs. 8 show sectional views illustrating a specific production method of a solar cell apparatus for realizing the structure of Figs. 6 and 7. The production steps are as follows.
8A A metal plate 8 is sucked with a heating-type vacuum suction plate (vacuum chuck) 13 and the suction plate is heated to about 400°C.
8B In the state of 8A, a p-type a-Si layer 3 is deposited by Cat-CVD. In the course of the deposition, doping gas is changed to deposit an n-type layer 4 and thereby to form a junction together with a p-type a-Si layer 3. In the course of the deposition, as occasion demands, the heating temperature of the metal plate 8 can be changed to improve the quality of the a-Si layer to be more suited for enhancing the performance characteristics of a solar cell.
8C In the state of 8B, photosensitive polymer (e.g., PIQ) 19 is coated while the substrate is being heated, and then baked at varied temperature.
8D In the state 8C, partially cured parts 20 of PIQ are formed by using a mask.
8E The polymer of the partially cured parts 20 is peeled off in a self-matching manner, and the a-Si layer of resulting exposed parts is removed by etching. 8F At the time when the above-mentioned step has been finished, the vacuum chuck for heating the substrate is returned to ordinary temperature, and glass or resin 21 is filled in till the midway of the n-type a-Si layer 4 of the groove region between the a-Si layers by means of spin coating, etc.
8G PIQ is again exposed to light to pattern a region 22 slightly wider than the groove region, and the polymer of partially cured region is peeled off in a self-matching manner.
8H Aluminum film is formed by vapor deposition or sputtering, then resist is coated thereon, and the aluminum is removed by photoetching to leave behind only the groove region 015 between a-Si islands, thus to form an upper electrode 5. The resulting system is detached from the vacuum chuck. Thus, a solar cell panel is completed.

In Figs. 8, in place of the photosensitive resin 21, an inorganic glass formed at low temperature may also be used. The upper electrode 5 may also be formed, in place of using photoetching, by means of printing, for example by rubbing silver paste into the concave part 15.

According to this Example, it has been confirmed that the occurrence of peeling, warping and cracking of film due to temperature change in heating, cooling, etc. in the production step of a large-area solar cell panel can be prevented and the development of defects in the production step can be avoided.

### Example 4

The solar cell apparatus obtained in Examples 1-3 can be placed in a large number on a Mega-Float constructed on the sea to build a power generation plant, and a high photoelectric conversion efficiency can be obtained thereby. Furthermore, the solar cell apparatus formed as in Examples 1-3 is high in productivity and hence excellent in economical efficiency. Moreover, when a solar cell apparatus is constructed such that panels more backward against the sun are at gradually higher positions and, at the same time, a rotating means controlled by personal computer which moves the panels to follow the shift of solar light such that the solar light enters always perpendicularly is provided, a high photoelectric conversion efficiency can be always obtained.

It should be further understood by those skilled in the art that although the foregoing description has been made on embodiments of the invention, the invention is not limited thereto and various changes and modifications may be made without departing from the spirit of the invention and the scope of the appended claims.

### EFFECTS OF THE INVENTION

According to this invention, there are provided a solar cell apparatus which has a high photoelectric conversion efficiency, is excellent in economical efficiency and is obtained by a stable production step which can prevent the occurrence of peeling, warping, cracking, etc. in the production step of the solar cell, a production method of the same, a metal plate for the same, and a power generating plant.

## Claims

1. A solar cell apparatus comprising a metal substrate (1), two silicon layers, one of the two silicon layers being formed in contact with a part of one surface of the metal substrate (1), a plurality of electrodes (2, 5) formed in contact with the other of the silicon layers, an external terminal (6, 7) formed on the other surface of the metal substrate (1), and an external terminal (6, 7) formed in contact with the electrode (2, 5).

2. A solar cell apparatus comprising a metal substrate (1) which has a plurality of projections formed on one surface thereof, two silicon layers, one of the two silicon layers being formed in contact with the projections, a plurality of electrodes (2, 5) formed in contact with the other of the silicon layers, an external terminal (6, 7) formed on the other surface of the metal substrate (1), and an external terminal (6, 7) formed in contact with the electrode (2, 5).

3. A solar cell apparatus comprising a metal substrate (1) in which a part of one surface thereof has been insulated, two silicon layers, one of the two silicon layers being formed in contact with a non-insulated part of the substrate, a plurality of electrodes (2, 5) formed in contact with the other of the silicon layers, an external terminal (6, 7) formed on the other surface of the metal substrate (1), and an external terminal (6, 7) formed in contact with the electrode (2, 5).

4. The solar cell apparatus according to claim 1 wherein a planar form of the electrode (2, 5) is of a lattice structure or a honey-comb structure.

5. The solar cell apparatus according to claim 1 wherein the metal substrate (1) comprises a component selected from the group consisting of aluminum, aluminum alloy, and nickel-iron based alloy containing 5-45% by weight of nickel.

6. A process for producing a solar cell apparatus comprising the steps of: forming projections on one surface of a metal substrate; forming a ceramics layer and a glass layer successively on said one surface; forming two silicon layers on a surface of the glass layer (11); forming a glass layer (11) on the surface of the silicon layers; forming a predetermined cut into the silicon layers through the glass layer (11); forming a plurality of through-holes in the glass layer (11) on the silicon layers so that the through-holes come in contact with an upper silicon layer of the silicon layers; forming an electrode in the through-hole; forming an antireflection film (16) on the glass layer (11) on the silicon layers; and forming external terminals (6, 7) on the electrode (2, 5) and on the other surface of the metal substrate (1).

7. The process for producing a solar cell apparatus according to claim 6, further including the step of forming an antireflection film (16) comprising a glass layer (11) by a sol-gel method.

8. A process for producing a solar cell apparatus comprising the steps of: forming two silicon layers on one surface of a metal substrate (1); forming a photosensitive polymer layer on the silicon layers and partially curing the polymer in a predetermined planar form; removing the partially cured part of the photosensitive polymer (14); removing, by etching, a part of the two silicon layers below the removed part of the photosensitive polymer (14), to form a through-hole which reaches a surface of the metal plate; filling an insulating material in the removed part of the silicon layers so that the insulating material reach a part of an upper silicon layer of the silicon layers removed by etching; forming an electrode (2, 5) on the insulating material; and forming external terminals (6, 7) on the electrode and on the other surface of the metal plate.

9. The process for producing a solar cell apparatus according to claim 6, wherein the two silicon layers are successively formed by means of a catalyst CVD by forming a p-type silicon layer (3) by doping a silicon layer with boron and then forming an n-type silicon layer (4) by doping a silicon layer with phosphorus.

10. The process for producing a solar cell apparatus according to claim 9, wherein the catalyst CVD is conducted by heating a tungsten wire to a high temperature to serve as a catalyst, forming the p-type silicon layer (3) by the use of monosilane and diborane gas, and then forming the n-type silicon layer (4) by the use of monosilane and phosphine gas.

11. A metal plate for a solar cell apparatus, which metal plate comprises a metal substrate (1) having a plurality of projections regularly arranged on one surface of the substrate (1).

12. A metal plate for a solar cell apparatus according to claim 11, having a thick part along a whole peripheral part of the substrate.

13. The metal plate for a solar cell apparatus according to claim 11 wherein the metal substrate (1) comprises a component selected from the group consisting of aluminum, aluminum alloy, and nickel-iron based alloy containing 35-45% by weight of nickel.

14. The metal plate for a solar cell apparatus according to claim 11 wherein each of the projections has a diameter of 0.2-0.8 mm and a height of 0.1-0.5 mm.

15. The metal plate for a solar cell apparatus according to claim 12 wherein an insulating layer is formed on the projections-formed surface.

16. The metal plate for a solar cell apparatus according to claim 15 wherein the insulating layer is formed on the peripheral part and a whole surface excluding edges of the projections.

17. A power generating plant provided with the solar cell apparatus according to claim 1.

18. A power generating plant provided with a solar cell apparatus produced by the process for producing a solar cell apparatus according to claim 6.

19. A power generating plant provided with a solar cell apparatus constructed by using the metal plate for a solar cell apparatus according to claim 11.
